# EUROPÄISCHE PATENTSCHRIFT

(11) **EP 3 379 906 B1**
(45) Veröffentlichungstag und Bekanntmachung des Hinweises auf die Patenterteilung: **04.08.2021**
(21) Anmeldenummer: 18155960.0
(22) Anmeldetag: 09.02.2018
(51) Int. Cl.: H05K 3/32, H05K 3/36, H01L 23/49, H05K 3/40, H05K 3/22, H01R 12/57, H01R 4/48, H01L 23/00, H05K 1/11

(54) **VERFAHREN ZUM HERSTELLEN VON BONDDRAHTVERBINDUNGEN MITTELS EINER ABSTÜTZUNG, SOWIE ENTSPRECHENDES ELEKTRONISCHES BAUTEIL**
METHOD FOR PRODUCING WIRE BOND CONNECTIONS WITH A SUPPORT STRUCTURE, AND THE CORRESPONDING ELECTRONIC DEVICE
PROCÉDÉ DE FABRICATION D'UNE CONNEXIONS À FIL AVEC UNE STRUCTURE DE SUPPORT, ET COMPOSANT ÉLECTRONIQUE ASSOCIÉ

(30) Priorität: 20.03.2017 AT 502202017
(43) Veröffentlichungstag der Anmeldung: 26.09.2018
(73) Patentinhaber: ZKW Group GmbH, 3250 Wieselburg (AT)
(72) Erfinder: Edlinger, Erik, 1090 Wien (AT); Dragosits, Bernd, 2560 Berndorf (AT); Führinger, Roman, 2803 Schwarzenbach (AT)
(74) Vertreter: Patentanwaltskanzlei Matschnig & Forsthuber OG

(56) Entgegenhaltungen:
- EP-A2- 2 418 738
- DE-U1-202016 106 235
- US-A- 3 626 086
- US-A- 4 294 008

## Beschreibung

Die Erfindung bezieht sich auf ein Verfahren zum Herstellen von Bondverbindungen zwischen elektrischen Anschlussstellen auf elektronischen Bauteilen, bei welchem mit Hilfe eines Bondwerkzeuges ein Bonddraht von einer ersten Anschlussstelle über die Bauteiloberfläche zu einer zweiten Anschlussstelle geführt wird, wobei an der ersten und an der zweiten Anschlussstelle eine Bondverbindung des Bonddrahtes mit einer Kontaktfläche der Anschlussstelle hergestellt wird, und vor dem Führen des Bonddrahtes von einer ersten zu einer zweiten Anschlussstelle auf dem Bauteil zumindest eine Abstützung für den Bonddraht errichtet wird, welche den Bonddraht in einem vorgegebenen Abstand von Oberflächenabschnitten des Bauteils hält.

Ebenso bezieht sich die Erfindung auf ein elektronisches Bauteil mit elektrischen Anschlussstellen, bei welchem ein zumindest Bonddraht von zumindest einer ersten Anschlussstelle über die Bauteiloberfläche zu zumindest einer zweiten Anschlussstelle geführt ist, wobei an der zumindest ersten und an der zumindest zweiten Anschlussstelle eine Bondverbindung des Drahtes mit einer Kontaktfläche der Anschlussstelle hergestellt ist, und auf dem Bauteil zumindest eine Abstützung für den zumindest einen Bonddraht vorgesehen ist und zumindest ein Bonddraht zwischen einer ersten Anschlussstelle und einer zweiten Anschlussstelle von der Abstützung in einem vorgegeben Abstand von Oberflächenabschnitten des Bauteils gehalten ist.

Das Drahtbonden ist ein dem Fachmann bekanntes Verfahren der Verbindungstechnik, das in großem Maßstab vor allem für das Verbinden elektrischer Anschlüsse auf Leiterplatten und Chipaufbauten verwendet wird. Meist wird mittels Ultraschalles ein Verbindungsdraht auf einer Kontaktfläche einer Leiterplatte angebracht, wobei der Verbindungsdraht (Bonddraht), der üblicherweise aus Aluminium, Kupfer, Silber oder Gold besteht, mit Hilfe eines Drahtbondingkopfes (auch als Bondingwerkzeug oder Wedge Tool bezeichnet) auf der Kontaktfläche angepresst wird. Gängige Drahtbondingköpfe weisen eine im Wesentlichen keilförmige Spitze mit einer Anpressfläche sowie eine Zuführung für den Bonddraht auf. Zum Herstellen der Bondverbindung wird der über die Anpressfläche geführte Bonddraht gegen die Kontaktfläche der Leiterplatte gepresst und gleichzeitig werden im Bondingkopf Ultraschallschwingungen erzeugt, wodurch der Draht mit der Kontaktfläche auf atomarer Ebene verbunden wird. Mit dem Bondingkopf kann am Ende des Bondingvorganges auch ein Trennen des fertig gebondeten Drahtes von einer Vorratsrolle erfolgen. Beispielsweise offenbart die US 3,934,783 eine derartige Bondingvorrichtung mit einem Bondingkopf.

Wenngleich Bonden für viele Anwendungsfälle die Verbindungstechnik der ersten Wahl ist, liegen jedoch oft Geometrien vor, bei welchen ein Standard-Bondprozess nicht eingesetzt werden kann, da entweder das Führen des Bonddrahtes nicht möglich ist und/oder das Bondingwerkzeug nur eingeschränkt verwendet werden kann. Soll beispielsweise eine Verbindung zwischen zwei rechtwinklig zueinander angeordneten, auf einem Modul gelegenen Leiterplatten hergestellt werden, muss das gesamte Modul während des Bondvorgangs um 90° gedreht werden, um erfolgreich bonden zu können. Wird ein Bonddraht über eine weite Strecke gespannt, kann möglicherweise der minimal notwendige Isolationsabstand zu einem Bauteil oder mechanischen Teil nicht eingehalten werden. Verwendet man eine Vielzahl von Bonddrähten mit komplexen Geometrien im Layout, so ist es nahezu unmöglich, eine passende Auslegung für den gespannten Bonddraht zu finden.

Derartige Abstützungen sind in unterschiedlichen Ausführungen den Dokumenten US 2012145446 A1, DE 102005036324A1, DE 102004018434 A1 und US 5847445 A entnehmbar, wobei diesen Abstützungen gemeinsam ist, dass sie einen zusätzliche Aufwand bei der Herstellung nach sich ziehen, da entweder das Ausgangsprodukt, z.B. eine Leiterplatte, speziell geformt werden muss oder später, im Allgemeinen vor einem Bestückungsprozess, besondere Arbeitsschritte mit entsprechenden Hilfsmittel erforderlich sind.

Das Dokument US 3 626 086 A zeigt ein Verdrahtungssystem, bei welchem ein elektronischer Bauteil mit Füßchen auf Lötpads einer Leiterplatte aufgelötet und von dieser in Abstand gehalten wird.

Die US 4 294 008 A beschreibt Abschnitte aus geschlitzten Rohr- oder Schlauchstückchen, welche auf eine Leiterplatte aufgeklebt sind und zur Führung von in ihnen enthaltenen Leitungen dienen.

Aus dem Dokument DE 20 2016 106235 U1 geht ein besonders ausgebildetes Kontaktstück hervor, dass auf einer Leiterplatte angelötet ist und zum Anklemmen und Halten von Leiterdrähten dient. Ein ähnliches Kontaktstück geht auch aus der EP 2 418 738 A2 als bekannt hervor.

Eine Aufgabe der Erfindung liegt darin, bei einem Verfahren bzw. einem Bauteil der eingangs genannten Art ein sicheres Bonden auch bei komplex angeordneten Bauteilen zu ermöglichen, wobei das Bereitstellen der Abstützungen ohne hohen Aufwand erfolgen kann.

Diese Aufgabe wird mit einem Verfahren der eingangs genannten Art gelöst, bei welchem erfindungsgemäß die zumindest eine Abstützung mit einem metallischen, lötbaren Fußabschnitt auf ein Lötpad des Bauteils aufgelötet und in SMT-Technologie oberflächenmontiert wird.

Dank der Erfindung können Abstützungen, die eine praktisch beliebige Leitungsführung von Bonddrähten ermöglich und die Bondstellen entlasten, einfach und billig hergestellt werden.

Bei einer zweckmäßigen Ausbildung ist vorgesehen, dass das Lötpad auf einer Leiterplatte des Bauteils ausgebildet ist.

Es kann auch empfehlenswert sein, dass die zumindest eine Abstützung aus einem Blechteil durch Stanzen und/oder Biegen hergestellt wird.

Bei einer anderen günstigen Variante ist vorgesehen, dass die zumindest eine Abstützung aus einem Drahtabschnitt durch Biegen hergestellt wird.

Auch kann mit Vorteil vorgesehen sein, dass der Bonddraht in die Aufnahme über einen federnden Abschnitt eingeführt wird, der nach dem Einführen des Bonddrahtes diesen gefangen hält. Dadurch lässt sich ein unbeabsichtigtes Ablösen des Bonddrahtes von den Abstützungen verhindern und daraus resultierende Folgeschäden, wie z.B. Kurzschlüsse.

Die gestellte Aufgabe wird auch mit einem elektronischen Bauteil der oben angegebenen Art gelöst, wobei erfindungsgemäß die zumindest eine Abstützung mit einem metallischen, lötbaren Fußabschnitt auf ein Lötpad des Bauteils aufgelötet ist und in SMT-Technologie oberflächenmontiert ist.

Eine vorteilhafte Variante sieht vor, dass das Lötpad auf einer Leiterplatte des Bauteils ausgebildet ist.

Bei einer anderen preisgünstigen Weiterbildung kann vorgesehen sein, dass die zumindest eine Abstützung aus einem gestanzten und/oder gebogenen Blechteil besteht.

Andererseits kann es vorteilhaft sein, wenn die zumindest eine Abstützung aus einem gebogenen Drahtabschnitt besteht.

Schließlich sieht eine noch andere günstige Variante vor, dass die Aufnahme einen federnden Abschnitt aufweist, der das Einführen des Bonddrahtes ermöglicht und nach Einführen des Bonddrahtes diesen gefangen hält. Dadurch lässt sich ein unbeabsichtigtes Ablösen des Bonddrahtes von den Abstützungen verhindern und daraus resultierende Folgeschäden, wie z.B. Kurzschlüsse.

Die Erfindung ist im Folgenden an Hand von Ausführungsbeispielen näher erläutert, die in der Zeichnung veranschaulicht sind. In dieser zeigen
Fig. 1 ein Kühlkörpermodul nach dem Stand der Technik mit zwei Leiterplatten, welche elektrisch miteinander zu verbinden sind,
Fig. 2 schematisch ein Kühlkörpermodul mit zwei orthogonal zueinander gelegenen Leiterplatten,
Fig. 3a und 3b Draufsichten auf eine Leiterplatte, die mit verschiedenen Bauteilen und zwei LED-Elementen bestückt ist, wobei in Fig. 3a eine herkömmliche Verbindung durch Bonden und in Fig. 3a eine Bondverbindung unter Verwendung von Abstützungen dargestellt ist, und die
Fig. 4a bis 4f Beispiele von für Biege- und Stanzteile in SMT-Technologie, die als Stützelemente im Rahmen der Erfindung verwendbar sind.

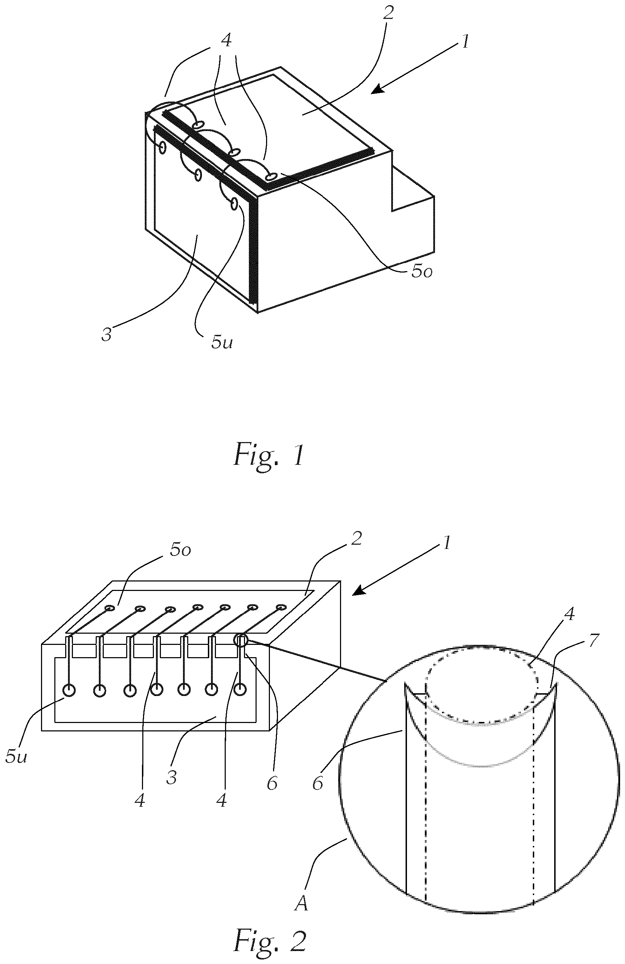

Nun wird unter Bezugnahme auf Fig. 1 die Problematik bei der Herstellung von Bondverbindungen an dem Beispiel eines Bauteils 1, z.B. eines Kühlkörpermoduls, mit zwei auf orthogonal zueinander ausgerichteten Seitenflächen des Bauteils angeordneten Leiterplatten 2, 3 erläutert. Die gebondeten Leitungen, d.h. die Bonddrähte 4, werden zwischen elektrischen Anschlussstellen auf elektronischen Bauteilen, hier den Leiterplatten, mit Hilfe eines bekannten, jedoch nicht dargestellten Bondwerkzeuges hergestellt. Dabei wird ein Bonddraht 4 von einer ersten Anschlussstelle 5o über die Oberfläche des Bauteils 1 zu einer zweiten Anschlussstelle 5u geführt, wobei an der ersten und an der zweiten Anschlussstelle 5o, 5u eine Bondverbindung des Drahtes 4 mit einer Kontaktfläche der jeweiligen Anschlussstelle hergestellt wird.

In diesen und ähnlichen Fällen ist ein Führen der Bonddrähte durch das Bondwerkzeug nicht oder nur schwer möglich. Man müsste das gesamte Bauteil 1 während des Bondvorganges um 90° drehen, um den Bondvorgang zu ermöglichen. Wird jedoch der Bonddraht über eine vergleichsweise lange Strecke gespannt, kann der vor allem in Hinblick auf die Isolation minimal notwendige Abstand zu elektronischen oder mechanischen Komponenten nicht eingehalten werden. Bei Verwendung einer Vielzahl von Bonddrähten und komplexen Geometrien im Layout ist es dann nahezu unmöglich, eine geeignete Auslegung für das Spannen der Bonddrähte zu finden.

Der verwendete Begriff "Bauteil" bzw. "elektronisches Bauteil" soll im Rahmen der beschriebenen Erfindung nicht nur den Grundkörper eines Bauteils beinhalten, sondern auch auf diesem angeordnete Komponenten, wie beispielsweise Leiterplatten, elektronische Komponenten oder auch nur eine Leiterplatte als solche. Weiters muss das Bauteil im Rahmen der Erfindung nicht notwendigerweise "elektronische" Komponenten enthalten, wesentlich sind lediglich elektrische Anschlussstellen, von welchen im Allgemeinen elektrische Verbindungen zu anderen Stellen des Bauteils verlaufen.

Um in solchen Fällen einen Bondvorgang zu erleichtern bzw. überhaupt zu ermöglichen, kann man vorsehen, dass vor dem Führen des Bonddrahtes von einer ersten zu einer zweiten Anschlussstelle auf dem Bauteil zumindest eine Abstützung für den Bonddraht errichtet wird, welche den Bonddraht in einem vorgegeben Abstand von Oberflächenabschnitten des Bauteils hält. Dies wird nun an einem ersten, in Fig. 2 dargestellten Beispiel erläutert. Hier ist, vergleichbar mit Fig. 1, wieder schematisch ein Bauteil 1 gezeigt, bei welchem auf zwei orthogonal zueinander ausgerichteten Seitenflächen Leiterplatten 2, 3 angeordnet sind. Auch hier werden Bonddrähte 4 von einer ersten Anschlussstelle 5o über die Oberfläche des Bauteils 1 zu einer zweiten Anschlussstelle 5u geführt, wobei an der ersten und an der zweiten Anschlussstelle 5o, 5u eine Bondverbindung des Drahtes 4 mit einer Kontaktfläche der jeweiligen Anschlussstelle 5o, 5u hergestellt wird.

Man erkennt nun, dass von dem in der Zeichnung oberen Rand der einen, in der Zeichnung vorderen Leiterplatte 3 stegförmige Abstützungen **6** abstehen, über deren Enden die Bonddrähte geführt werden können, wobei diese Abstützungen 6 die Bonddrähte in einem vorgegebenen Abstand von Oberflächenabschnitten des Bauteils einschließlich der zu diesem gehörigen Leiterplatten 2, 3 hält.

Wie in dem Detail **A** ersichtlich, ist bei dem gezeigten Beispiel in den Enden der Abstützungen 6 je eine abgerundete Vertiefung **7** ausgeformt, welche ein Abrutschen der Bonddrähte 4 verhindert. Die Abstützungen 6 sind bei dem Ausführungsbeispiel einstückig mit den Leiterplatten und bestehen daher aus demselben Material, z.B. FR4, wie diese. Abstützungen könnten hier auch an beiden Leiterplatten vorgesehen sein und sie müssen auch nicht einstückig mit den Leiterplatten sein, sondern können mit diesen durch eine Klebeverbindung verbunden sein.

Die Ausbildung gemäß Fig. 2 gehört im Wesentlichen dem Stand der Technik an.

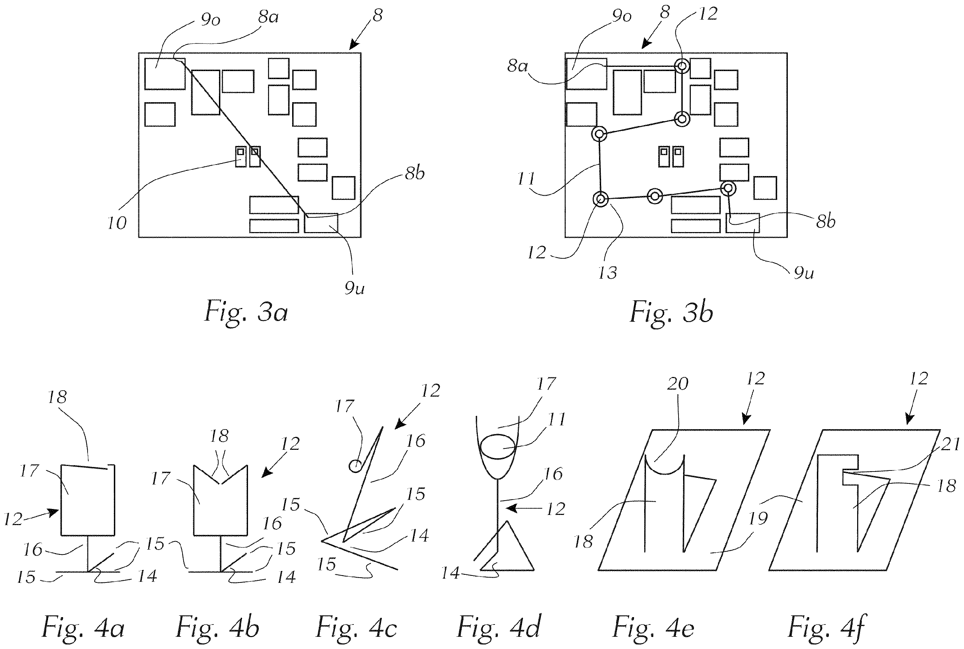

Anhand der Fig. **3a** und **3b** ist eine andere Ausführungsform eines Bauteils **8,** nämlich einer Leiterplatte dargestellt, die mit mehreren Modulen, von welchen zwei Module mit **9o** und **9u** bezeichnet sind, und zwei LED-Elementen **10** bestückt ist, wobei in Fig. 3a eine Verbindung durch Bonden ohne Abstützungen und in Fig. 3a eine Bondverbindung mit Abstützungen dargestellt ist. Im Einzelnen erkennt man, dass eine Bondverbindung durch einen Bonddraht zwischen zwei Modulen 9o, 9u hergestellt werden soll, die sich in der Zeichnung links oben und rechts unten befinden. Geht man dabei nach Fig. 3a vor, so wird ein Bonddraht **11** mittels eines Bondwerkzeuges geradlinig von einer Anschlussstelle 8a des Moduls 9o zu einer entsprechenden Anschlussstelle 8b des Moduls 9u geführt, wobei er in diesem Fall den Abstrahlbereich der beiden LED-Elemente 10 kreuzt und die Abstrahlung zumindest beeinträchtigt. Überdies kreuzt der Bonddraht weitere Module und kann an diesen in unerwünschter Weise anliegen.

Gemäß Fig. 3b werden auf dem Bauteil 8 in weiter unten näher erläuterter Weise Abstützungen **12** errichtet, und der Bonddraht 11 wird von dem Bondwerkzeug in programmierter Weise so geführt, dass er von dem in der Zeichnung links oben auf dem Bauteil 8 gelegenen Modul 9o über insgesamt sechs Abstützungen 12 so zu dem Modul 9u rechts unten geführt wird, dass er in einem geeigneten vorgegebenen Abstand von sämtlichen Modulen bzw. der Oberfläche des Bauteils 8 liegt und auch die Abstrahlung der LED-Elemente 10 nicht beeinträchtigt.

Im Falle der Fig. 3b sind die Abstützungen 12 nicht einstückig mit einer Leiterplatte des Bauteils 8 ausgebildet, sondern sie sind mit einem Fußabschnitt auf ein Lötpad 13 des als Leiterplatte ausgebildeten Bauteils 8 aufgelötet. Dabei muss bedacht werden, dass die Abstützungen 12 für den geführten Bonddraht im Allgemeinen eine Isolierfunktion hinsichtlich anderer Bauteile und Leiterzüge zeigen sollen. Falls die Abstützungen 12 ganz aus Metall bestehen, müssen die Lötpads 13 im Allgemeinen gegen andere Leiterzüge isoliert sein. Andererseits können die Abstützungen 12 auch aus Isoliermaterial bestehen und z.B. auf das Bauteil 8 aufgeklebt sein oder sie können teilweise aus Isoliermaterial bestehen und erfindungsgemäß einen metallischen Fußabschnitt besitzen, mit dem sie auf Lötpads aufgelötet sind. Die Abstützungen 12 können jedoch auch metallisch sein bzw. aus leitendem Material bestehen.

In der Draufsicht der Fig. 3b sind die Abstützungen mit kleinen Ringen schematisch dargestellt, einige mögliche konkrete Ausführungen sind nun in den folgenden Fig. 4a bis 4f gezeigt, wobei zur Vereinfachung für alle Ausführungen der Stützen das Bezugszeichen 12 und für deren Fußabschnitt das Bezugszeichen **14** verwendet wird. Auch werden in den Fig. 4a bis 4f für gleiche oder vergleichbare Teile gleiche Bezugszeichen verwendet.

**Fig. 4a** zeigt eine Abstützung 12, die aus Draht oder Blechstreifen besteht, wobei von einem Fußabschnitt 14, der hier drei unter einem Winkel gegeneinander angeordnete Finger **15** besitzt, mit welchen er auf ein Lötpad oder sonst eine metallische Fläche aufgelötet werden kann. Von dem Fußabschnitt 14 steht ein Stängel **16** nach oben ab, an dessen oberen Ende eine Aufnahme **17** für einen hier nicht gezeigten Bonddraht anschließt. An ihrem oberen Ende besitzt die Aufnahme 17 einen vorzugsweise federnden Abschnitt **18,** der das Einführen eines Bonddrahtes ermöglicht, dann aber zurückfedert und den Bonddraht gefangen hält. Eine ähnliche Ausführung ist in **Fig. 4b** dargestellt, doch sind hier zwei federnde Abschnitte 18 vorgesehen.

**Fig. 4c** zeigt gleichfalls eine mit den beiden zuvor beschriebenen Ausführungen ähnliche Variante, bei welcher von einem Fußabschnitt 14 mit drei Fingern 15 ein Stängel 16 nach oben verläuft, der in seinem oberen Endbereich eine ringförmige Aufnahme 17 für einen Bonddraht trägt. Der z.B. aus Draht oder aus einem Drahtstreifen bestehende Ring dieser Aufnahme ist jedoch nicht geschlossen, sondern kann sich bei Auflegen eines Bonddrahtes federnd öffnen und darnach zumindest teilweise wieder schließen, sodass auch in diesem Fall der Bonddraht gefangen und gehalten bleibt.

Bei der Variante nach **Fig. 4d** ist - so wie bei den vorgehenden Ausführungsformen - ein Fußabschnitt 14 mit einem nach oben ragenden Stängel 16 vorhanden, der oben eine in Seitenansicht becherförmige Aufnahme 17 für einen hier eingezeichneten Bonddraht 11 trägt.

Zwei weitere Varianten von Abstützungen 12 sind in den **Fig. 4e** und **4f** dargestellt. In beiden Fällen ist Ausgangspunkt ein beispielsweise rechteckförmiges Blechstück, aus welchem nach Ausstanzen oder Einschneiden ein Stützflügel **18** hochgebogen wird. Der verbleibende Teil des Blechstückes dient als Fußabschnitt **19,** der beispielsweise auf eine Leiterplatte aufgelötet werden kann. Um einen Bonddraht in einem gewissen Ausmaß zu fixieren, ist an dem oberen Ende des Stützflügels 18 gemäß Fig. 4e eine abgerundete Vertiefung **20,** beispielsweise durch Stanzen, ausgebildet, welche eine Auflage für einen Bonddraht darstellt und dessen seitliches Verrutschen verhindert, jedenfalls solange nicht größere Kräfte an diesem angreifen bzw. der Bonddraht entsprechend gespannt ist. Auch gewährleistet diese Vertiefung 20, ebenso wie die Vertiefung 7 der Fig. 2, Detail A, ein gewisses Zentrieren des Bonddrahtes während seines Verlegens durch ein Bondwerkzeug. Bei der Variante nach Fig.4f ist in dem Stützflügel 18 ein seitlicher Einschnitt **21** ausgebildet, beispielsweise durch Stanzen. In einem solchen Einschnitt 21 kann ein Bonddraht mit Vorteil dann gehalten werden, wenn die Stütze einen Umlenkpunkt für den Bonddraht bilden soll, nämlich einen Punkt, an dem der Bonddraht seitlich umgelenkt wird, wie dies an mehreren Stellen der Fig. 3b für den Bonddraht 11 gezeigt ist.

Falls zumindest der jeweilige Fußabschnitt 14 bzw. 19 aus lötbarem Metall besteht, können Abstützungen gemäß der Erfindung in vorteilhafter Weise während der Bestückung einer Leiterplatte zusammen mit anderen Komponenten auf diese insbesondere durch eine SMT-Löttechnologie aufgelötet werden. Unter "Surface Mounted Technology" mit der gebräuchlichen Abkürzung SMT versteht man die Technologie von "oberflächenmontierten" Bauelementen.

Der Bondprozess ist, wie das folgende Beispiel zeigen soll, bei der Herstellung eines erfindungsgemäßen Bauteils in zwei Schritten einfach integrierbar. Diese Schritte sind der SMD-Prozess zum Bestücken und Löten von oberflächenmontierbaren Bauteilen und das darauf folgende Assemblieren, bei dem auf Sondermaschinen z.B. eine Leiterplatte mit einem Kühlkörper verbunden wird. Bei diesem Assemblieren kann das Legen der Bonddrähte sequentiell integriert werden. Auf der SMD-Linie werden zunächst diejenigen Metallpads, die zum Verbinden von SMD-Komponenten vorgesehen sind, mit Lot bedruckt, danach werden SMD-Bauelemente darauf bestückt und durch gemeinsames Aufschmelzen verlötet. Bondpads, auf die in einem nachfolgenden Bondprozess ein Bonddraht aufgesetzt werden soll, werden nicht bedruckt und sollten bei der erhöhten Temperatur des Lötvorgangs an der Oberfläche nicht weiter oxidieren. Dazu wird einerseits unter StickstoffAtmosphäre mit einem Rest-Sauerstoffgehalt von ca. 500 ppm gelötet, andererseits können zum Bonden Ni/Au-Pads mit einer Ni-Dicke von ca. 7 µm und einer Au-Dicke von unter 100 nm verwendet werden.

**Liste der Bezugszeichen**

| | | | |
|---|---|---|---|
| 1 | Bauteil | 11 | Bonddraht |
| 2 | Leiterplatte | 12 | Abstützung |
| 3 | Leiterplatte | 13 | Lötpad |
| 4 | Bonddraht | 14 | Fußabschnitt |
| 50 | erste Anschlussstelle | 15 | Finger |
| 5u | zweite Anschlussstelle | 16 | Stängel |
| 6 | Abstützung | 17 | Aufnahme |
| 7 | Vertiefung | 18 | Stützflügel |
| 8 | Bauteil | 19 | Fußabschnitt |
| 90 | Modul | 20 | Vertiefung |
| 9u | Modul | 21 | Einschnitt |
| 10 | LED-Element | | |

## Patentansprüche

1. Verfahren zum Herstellen von Bondverbindungen zwischen elektrischen Anschlussstellen auf elektronischen Bauteilen (8), bei welchem mit Hilfe eines Bondwerkzeuges ein Bonddraht (11) von einer ersten Anschlussstelle über die Bauteiloberfläche zu einer zweiten Anschlussstelle geführt wird, wobei an der ersten (8a) und an der zweiten (8b) Anschlussstelle eine Bondverbindung des Bonddrahtes mit einer Kontaktfläche der Anschlussstelle hergestellt wird, und vor dem Führen des Bonddrahtes (11) von einer ersten zu einer zweiten Anschlussstelle auf dem Bauteil (8) zumindest eine Abstützung (12) für den Bonddraht errichtet wird, welche den Bonddraht in einem vorgegebenen Abstand von Oberflächenabschnitten des Bauteils hält,
**dadurch gekennzeichnet, dass**
die zumindest eine Abstützung (12) mit einem metallischen, lötbaren Fußabschnitt (14, 19) auf ein Lötpad (13) des Bauteils (8) aufgelötet und in SMT-Technologie oberflächenmontiert wird.

2. Verfahren nach Anspruch 1, **dadurch gekennzeichnet, dass** das Lötpad (13) auf einer Leiterplatte des Bauteils (8) ausgebildet ist.

3. Verfahren nach Anspruch 1 oder 2, **dadurch gekennzeichnet, dass** die zumindest eine Abstützung (12) aus einem Blechteil durch Stanzen und/oder Biegen hergestellt wird.

4. Verfahren nach Anspruch 1 oder 2 **dadurch gekennzeichnet, dass** die zumindest eine Abstützung (12) aus einem Drahtabschnitt durch Biegen hergestellt wird.

5. Verfahren nach einem der Ansprüche 1 bis 4, **dadurch gekennzeichnet, dass** der Bonddraht (11) in die Aufnahme (17) über einen federnden Abschnitt (18) eingeführt wird, der nach dem Einführen des Bonddrahtes diesen gefangen hält.

6. Elektronisches Bauteil (8) mit elektrischen Anschlussstellen, bei welchem zumindest ein Bonddraht (11) von zumindest einer ersten Anschlussstelle über die Bauteiloberfläche zu zumindest einer zweiten Anschlussstelle geführt ist, wobei an der zumindest ersten und an der zumindest zweiten Anschlussstelle eine Bondverbindung des Drahtes mit einer Kontaktfläche der Anschlussstelle hergestellt ist, und auf dem Bauteil (8) zumindest eine Abstützung (12) für den zumindest einen Bonddraht (11) vorgesehen ist und zumindest ein Bonddraht zwischen einer ersten Anschlussstelle und einer zweiten Anschlussstelle von der Abstützung in einem vorgegeben Abstand von Oberflächenabschnitten des Bauteils gehalten ist,
**dadurch gekennzeichnet, dass**
die zumindest eine Abstützung (12) mit einem metallischen, lötbaren Fußabschnitt (14, 19) auf ein Lötpad (13) des Bauteils (8) aufgelötet ist und in SMT-Technologie oberflächenmontiert ist.

7. Elektronisches Bauteil nach Anspruch 6, **dadurch gekennzeichnet, dass** das Lötpad (13) auf einer Leiterplatte des Bauteils (8) ausgebildet ist.

8. Elektronisches Bauteil nach Anspruch 6 oder 7, **dadurch gekennzeichnet, dass** die zumindest eine Abstützung (12) aus einem gestanzten und/oder gebogenen Blechteil besteht.

9. Elektronisches Bauteil nach Anspruch 6 oder 7, **dadurch gekennzeichnet, dass** die zumindest eine Abstützung (12) aus einem gebogenen Drahtabschnitt besteht.

10. Elektronisches Bauteil nach einem der Ansprüche 6 bis 9, **dadurch gekennzeichnet, dass** die Aufnahme (17) einen federnden Abschnitt (18) aufweist, der das Einführen des Bonddrahtes (11) ermöglicht und nach Einführen des Bonddrahtes diesen gefangen hält.

## Claims

1. Method for producing bonding connections between electrical connection points on electronic components (8), in which a bonding wire (11) is guided from a first connection point over the component surface to a second connection point with the aid of a bonding tool, wherein a bonding connection of the bonding wire to a contact surface of the connection point being produced at the first (8a) and at the second (8b) connection point, and before the bonding wire (11) is guided from a first to a second connection point, at least one support (12) for the bonding wire is erected on the component (8), which support (12) holds the bonding wire at a predetermined distance from surface portions of the component,
**characterized in that**
the at least one support (12) is soldered with a metallic, solderable foot section (14,19) onto a solder pad (13) of the component (8) and is surface-mounted using SMT technology.

2. Method according to claim 1, **characterized in that** the solder pad (13) is formed on a printed circuit board of the component (8).

3. Method according to claim 1 or 2, **characterized in that** the at least one support (12) is produced from a sheet metal part by punching and/or bending.

4. Method according to claim 1 or 2, **characterized in that** the at least one support (12) is produced from a wire section by bending.

5. Method according to any one of claims 1 to 4, **characterized in that** the bonding wire (11) is inserted into the receptacle (17) via a resilient section (18) which, after insertion of the bonding wire, holds it captive.

6. Electronic component (8) with electrical connection points, in which at least one bonding wire (11) is guided from at least one first connection point via the component surface to at least one second connection point, wherein a bonding connection of the wire to a contact surface of the connection point being produced at the at least first and at the at least second connection point, and at least one support (12) for the at least one bonding wire (11) is provided on the component (8), and at least one bonding wire is held between a first connection point and a second connection point by the support at a predetermined distance from surface portions of the component,
**characterised in that**
the at least one support (12) is soldered with a metallic, solderable foot portion (14,19) onto a solder pad (13) of the component (8) and is surface-mounted in SMT technology.

7. Electronic component according to claim 6, **characterized in that** the solder pad (13) is formed on a printed circuit board of the component (8).

8. Electronic component according to claim 6 or 7, **characterized in that** the at least one support (12) consists of a stamped and/or bent sheet metal part.

9. Electronic component according to claim 6 or 7, **characterized in that** the at least one support (12) consists of a bent wire section.

10. Electronic component according to any one of claims 6 to 9, **characterized in that** the receptacle (17) has a resilient portion (18) which allows the insertion of the bonding wire (11) and, after insertion of the bonding wire, holds its captive.

## Revendications

1. Procédé pour réaliser des liaisons de connexion entre des points de connexion électriques sur des composants électroniques (8), dans lequel un fil de connexion (11) est guidé à l'aide d'un outil de connexion depuis un premier point de connexion sur la surface du composant jusqu'à un deuxième point de connexion, une liaison de connexion du fil de connexion avec une surface de contact du point de connexion étant réalisée au premier (8a) et au deuxième (8b) point de connexion, et avant que le fil de liaison (11) ne soit guidé d'un premier à un second point de connexion, au moins un support (12) pour le fil de liaison est érigé sur le composant (8), lequel support maintient le fil de liaison à une distance prédéterminée des parties de surface du composant,
**caractérisé en ce que**
le au moins un support (12) est soudé avec une section de pied métallique soudable (14, 19) sur une plage de soudure (13) du composant (8) et est monté en surface en utilisant la technologie SMT.

2. Procédé selon la revendication 1, **caractérisé en ce que** la plage de soudure (13) est formée sur une carte de circuit imprimé du composant (8).

3. Procédé selon la revendication 1 ou 2, **caractérisé en ce que** l'au moins un support (12) est réalisé à partir d'une pièce de tôle par poinçonnage et/ou pliage.

4. Procédé selon la revendication 1 ou 2, **caractérisé en ce que** le au moins un support (12) est réalisé à partir d'une partie en fil métallique par pliage.

5. Procédé selon l'une quelconque des revendications 1 à 4, **caractérisé en ce que** le fil de liaison (11) est inséré dans le réceptacle (17) par l'intermédiaire d'une portion élastique (18) qui, après insertion du fil de liaison, maintient son captif.

6. Composant électronique (8) avec des points de connexion électrique, dans lequel au moins un fil de liaison (11) est guidé d'au moins un premier point de connexion à au moins un deuxième point de connexion en passant par la surface du composant, une liaison par adhérence du fil avec une surface de contact du point de connexion étant réalisée au niveau du au moins premier et du au moins deuxième point de connexion, et au moins un support (12) pour le au moins un fil de liaison (11) est prévu sur le composant (8), et au moins un fil de liaison est maintenu entre un premier point de connexion et un deuxième point de connexion par le support à une distance prédéterminée des parties de surface du composant,
**caractérisé en ce que**
l'au moins un support (12) est soudé avec une partie de pied métallique soudable (14, 19) sur une plage de soudure (13) du composant (8) et est monté en surface en technologie SMT.

7. Composant électronique selon la revendication 6, **caractérisé en ce que** la plage de soudure (13) est formée sur une carte de circuit imprimé du composant (8).

8. Composant électronique selon la revendication 6 ou 7, **caractérisé en ce que** l'au moins un support (12) est constitué d'une pièce de tôle emboutie et/ou pliée.

9. Composant électronique selon la revendication 6 ou 7, **caractérisé en ce que** l'au moins un support (12) est constitué d'une partie en fil métallique plié.

10. Composant électronique selon l'une quelconque des revendications 6 à 9, **caractérisé en ce que** le réceptacle (17) comporte une partie élastique (18) qui permet l'insertion du fil de connexion (11) et, après insertion du fil de connexion, maintient son captif.
